# EUROPEAN PATENT SPECIFICATION

(11) **EP 4 307 386 B1**
(45) Date of publication and mention of the grant of the patent: **08.04.2026**
(21) Application number: 23175177.7
(22) Date of filing: 24.05.2023
(51) Int. Cl.: H10D 30/67, H10D 64/68, H10B 12/00

(54) **SEMICONDUCTOR DEVICE**
HALBLEITERANORDNUNG
DISPOSITIF SEMI-CONDUCTEUR

(30) Priority: 14.07.2022 KR 20220086789
(43) Date of publication of application: 17.01.2024
(73) Proprietor: Samsung Electronics Co., Ltd., Suwon-si, Gyeonggi-do 16677 (KR)
(72) Inventor: LEE, Sangho, 16677 Suwon-si (KR); JEONG, Moonyoung, 16677 Suwon-si (KR); NOH, Hyungjun, 16677 Suwon-si (KR)
(74) Representative: Marks & Clerk LLP

(56) References cited:
- KR-A- 20110 089 045
- US-A1- 2009 042 347
- US-A1- 2016 181 377
- US-A1- 2017 330 965
- US-A1- 2022 077 320

## Description

### BACKGROUND

The subject matter of the present disclosure relates to a semiconductor device.

Due to the development of the electronics industry and the needs of users, electronic devices are becoming smaller and higher in performance. Accordingly, semiconductor devices used in electronic devices are also required to be highly integrated and to have high-performance.

United States Patent Application Publication US2017/330965A1 relates to a transistor that includes a vertical channel fin directly on a bottom source/drain region. A gate stack is formed on sidewalls of the vertical channel fin. A top spacer is formed over the gate stack. The top spacer has air gaps directly above the gate stack. A top source/drain region is formed directly on a top surface of the vertical channel fin.

Korean Patent Application Publication KR20110089045A relates to a vertical thin film transistor. A substrate includes a lower electrode layer. An intermediate structure including a first insulating layer pattern, a conductive thin film pattern, and a second insulating layer pattern is formed on the top of the substrate. A dielectric layer is formed on the sidewall of the conductive thin film pattern of the intermediate structure. An active layer is formed on the top of the substrate using an organic semiconductor compound. A top electrode layer is formed on the active layer.

### SUMMARY

Example implementations provide a semiconductor device in which high integration may be provided or electrical characteristics may be improved. To address demands from the semiconductor industry regarding size and integration, the present disclosure includes forming a spacer structure for spacing between adjacent conductive structures. In some implementations, within the spacer structure, a dielectric layer between a back gate electrode and a vertical channel region can include an air gap, which has a low dielectric constant ("low-κ"), which can allow for a high degree of integration while having improved electrical characteristics. In some implementations, the sequence of layers of in a vertical channel transistor (VCT) structure, combining a dielectric structure having more than one layer with an air gap, or both can improve the electric characteristics.

In general, innovative aspects of the subject matter described in this specification can be embodied by a semiconductor device that includes: a vertical pattern including a first source/drain region, a second source/drain region at a height higher than a height of the first source/drain region, and a vertical channel region between the first and second source/drain regions, a front gate structure facing a first side surface of the vertical pattern, and a back gate structure facing a second side surface of the vertical pattern, opposite to the first side surface of the vertical pattern. The front gate structure includes a gate electrode on the first side surface of the vertical pattern, and a gate dielectric layer including a portion between the vertical pattern and the gate electrode. The back gate structure includes a back gate electrode on the second side surface of the vertical pattern, and a dielectric structure including a portion between the vertical pattern and the back gate electrode. The dielectric structure includes an air gap.

In general, in another aspect, the subject matter of the present disclosure can be embodied in a semiconductor device that includes: a vertical pattern including a first source/drain region, a second source/drain region at a height higher than a height of the first source/drain region, and a vertical channel region between the first and second source/drain regions, a gate structure facing a first side surface of the vertical pattern, and a back gate structure facing a second side surface, opposite to the first side surface of the vertical pattern. The gate structure includes a gate electrode on the first side surface of the vertical pattern, and a gate dielectric layer including a portion between the vertical pattern and the gate electrode. The back gate structure includes a back gate electrode on the second side surface of the vertical pattern, a dielectric structure including a portion between the vertical pattern and the back gate electrode, a first auxiliary structure on the back gate electrode and the dielectric structure, and a second auxiliary structure below the back gate electrode. The dielectric structure includes an air gap. The first auxiliary structure defines an upper surface of the dielectric structure. The second auxiliary structure defines a lower surface of the air gap.

The invention is defined by claim 1. Preferred embodiments are defined in the dependent claims.

### BRIEF DESCRIPTION OF DRAWINGS

The above and other aspects, features, and advantages of the present disclosure will be more clearly understood from the following detailed description, taken in conjunction with the accompanying drawings, in which:
FIG. 1 is a schematic plan view of an example of a semiconductor device;
FIG. 2 is a schematic cross-sectional view of the semiconductor device of FIG. 1;
FIG. 3 is a partially enlarged cross-sectional view of the semiconductor device of FIG. 1;
FIGS. 4A to 4E are partially enlarged cross-sectional views of an example of semiconductor devices;
FIG. 5 is a schematic cross-sectional view of an example of a semiconductor device;
FIG. 6 is a schematic cross-sectional view of an example of a semiconductor device;
FIG. 7 is a schematic cross-sectional view of an example of a semiconductor device;
FIGS. 8A to 21B are schematic views illustrating an example of a method of manufacturing a semiconductor device; and
FIGS. 22A to 24 are schematic views illustrating an example of a method of manufacturing a semiconductor device.

### DETAILED DESCRIPTION

Hereinafter, terms such as "upper", "middle" and "lower" may be replaced with other terms, for example, "first", "second", and "third" to describe the elements of the specification. Terms such as "first", "second" and "third" may be used to describe various components, but the components are not limited by the terms, and "first component" may mean " second component" and vice versa.

Hereinafter, various examples will be described in detail with reference to the accompanying drawings.

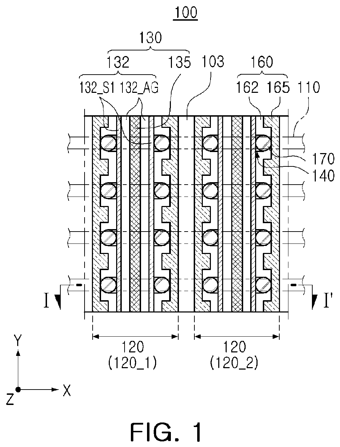

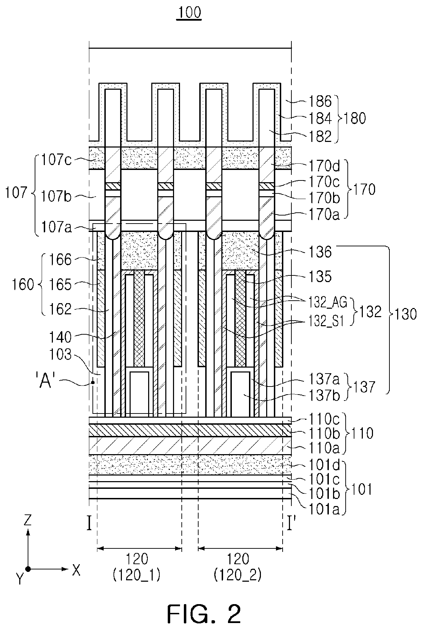

FIG. 1 is a schematic plan view of an example of a semiconductor device. FIG. 1 illustrates including a planar part of the area in which the air gap 132_AG (see FIG. 2) is disposed.

FIG. 2 is a schematic cross-sectional view of the semiconductor device of FIG. 1. FIG. 2 illustrates a cross-section taken along line I-I' of FIG. 1.

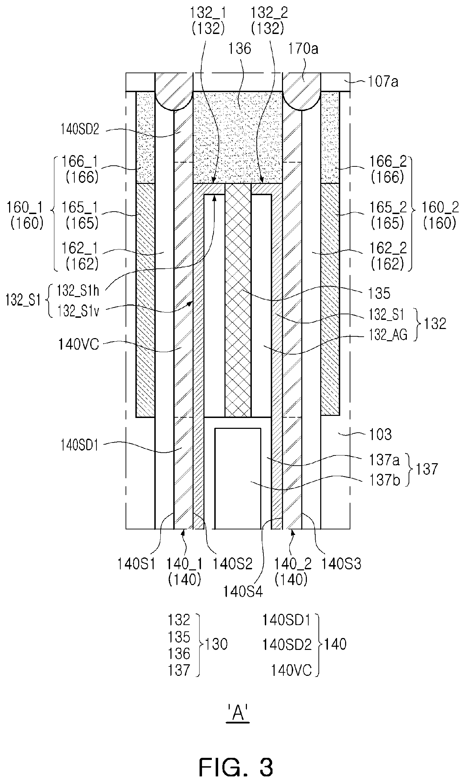

FIG. 3 is a partially enlarged cross-sectional view of the semiconductor device of FIG. 1. FIG. 3 is an enlarged view of area 'A' of FIG. 2.

Referring to FIGS. 1 to 3, a semiconductor device 100 may include lower insulating layers 101, a bit line structure 110 extending in a first horizontal direction, for example, an X direction on the lower insulating layers 101, line structures 120 spaced apart from each other on the lower insulating layers 101 and the bit line structure 110 and extending in a second horizontal direction, for example, a Y-direction, an intermediate insulating layer 103 covering side surfaces of the line structures 120 on the lower insulating layers 101 and the bit line structure 110, upper insulating layers 107 on the intermediate insulating layer 103, information storage structures 180 on the upper insulating layers 107, and contact patterns 170 connecting the line structures 120 and the information storage structures 180 by penetrating through the upper insulating layers 107.

In some implementations, the line structures 120 includes a first line structure 120_1 and a second line structure 120_2 that are spaced apart from each other in the first horizontal direction X and extend in parallel.

Each of the line structures 120 may include a back gate structure 130, vertical patterns 140 intermittently extending in the second horizontal Y-direction on both sides of the back gate structure 130, and front gate structures 160 disposed on at least one side of the vertical patterns 140. Each of the vertical patterns 140 may include a first source/drain region 140SD1, a second source/drain region 140SD2 at a height higher than the first source/drain region 140SD1, and a vertical channel region 140VC between the first and second source/drain regions 140SD1 and 140SD2.

The semiconductor device 100 may include a vertical channel transistor comprised of vertical patterns 140, a bit line structure 110 electrically connected to the vertical patterns 140, and front gate structures 160 disposed on at least one side of the vertical patterns 140.

The semiconductor device 100 may be applied to, for example, a cell array of a dynamic random access memory (DRAM), but the present disclosure is not limited thereto.

The lower insulating layers 101 may include an insulating material such as silicon oxide, silicon nitride, silicon oxynitride (SiON), or silicon carbonitride (SiCN).

In some implementations, the lower insulating layers 101 include first to fourth lower insulating layers 101a, 101b, 101c, and 101d sequentially stacked. The first lower insulating layer 101a may be an adhesive layer for bonding to another structure, and the fourth lower insulating layer 101d may be an insulating layer covering the lower surface of the bit line structure 110. However, the material and the number of layers of the lower insulating layers 101 may be variously changed.

The bit line structure 110 may extend in the first horizontal direction X on the lower insulating layers 101. In some implementations, the bit line structure 110 is buried in the lower insulating layers 101. For example, the fourth lower insulating layer 101d may cover the lower surface and side surfaces of the bit line structure 110.

The bit line structure 110 may be electrically connected to the vertical pattern 140. For example, the bit line structure 110 may be in contact with and electrically connected to the first source/drain region 140SD1 of the vertical pattern 140.

The bit line structures 110 may be provided as a plurality of bit line structures 110, and the plurality of bit line structures 110 may be spaced apart from each other in a direction perpendicular to the first horizontal direction and may extend in parallel.

The bit line structure 110 may include doped polysilicon, metal, conductive metal nitride, metal-semiconductor compound, conductive metal oxide, conductive graphene, carbon nanotube, or combinations thereof. For example, the bit line structure 110 may be formed of doped polysilicon, Al, Cu, Ti, Ta, Ru, W, Mo, Pt, Ni, Co, TiN, TaN, WN, NbN, TiAl, TiAlN, TiSi, TiSiN, TaSi, TaSiN, RuTiN, NiSi, CoSi, IrOₓ, RuOₓ, graphene, carbon nanotubes, or combinations thereof. In some implementations, the bit line structure 110 includes first to third conductive patterns 110a, 110b, and 110c sequentially stacked on the lower insulating layers 101. The first conductive pattern 110a may include a metal material, for example, such as titanium (Ti), tantalum (Ta), tungsten (W), and aluminum (Al), the second conductive pattern 110b may include, for example, a metal nitride such as titanium nitride (TiN) or a silicide material such as titanium silicide (TiSi), and the third conductive pattern 110c may include a semiconductor material such as polycrystalline silicon. The third conductive pattern 110c may be a layer doped with impurities. However, the material, the number of layers, and the thickness of the layers constituting the bit line structure 110 may be variously changed.

Each of the vertical patterns 140 may include a first source/drain region 140SD1 in contact with the bit line structure 110, a second source/drain region 140SD2 in contact with the contact pattern 170, and a vertical channel region 140VC between the first and second source/drain regions 140SD1 and 140SD2.

In some implementations, the first and second source/drain regions 140SD1 and 140SD2 are of a first conductivity type, and the vertical channel region 140VC has a second conductivity type different from the first conductivity type, or is an undoped intrinsic region. For example, the first conductivity type may be an N-type conductivity type, and the second conductivity type may be a P-type conductivity type.

In some implementations, the vertical patterns 140 include a single crystal semiconductor material. The single crystal semiconductor material may include a group IV semiconductor, a group III-V compound semiconductor, or a group II-VI compound semiconductor, and for example, may be a single crystal semiconductor including at least one of silicon, silicon carbide, germanium, or silicon-germanium. However, in some implementations, the vertical patterns 140 include at least one of a polycrystalline semiconductor material, an oxide semiconductor material such as indium gallium zinc oxide (IGZO), or a two-dimensional material such as MoS₂ or the like.

The vertical patterns 140 may include first vertical patterns 140_1 arranged while being spaced apart from each other in the second horizontal direction (Y), and second vertical patterns 140_2 arranged to be spaced apart from each other in the second horizontal direction and spaced apart from the first vertical patterns 140_1 in the first horizontal direction (X). The first vertical patterns 140_1 may be disposed on one side of the back gate structure 130, and the second vertical patterns 140_2 may be disposed on the other side of the back gate structure 130 opposite to the one side.

The back gate structure 130 may cross the upper surface of the bit line structure 110 on the lower insulating layers 101 and extend in the second horizontal direction (Y).

The back gate structure 130 may include a back gate electrode 135 extending in the second horizontal direction (Y), dielectric structures 132 disposed on both sides of the back gate electrode 135, a first auxiliary structure 136 on the back gate electrode 135, a second auxiliary structure 137 below the back gate electrode 135.

The back gate electrode 135 may serve to remove charges trapped in the vertical channel region 140VC of each of the vertical patterns 140. The vertical channel regions 140VC may be a floating body, and the back gate electrode 135 may be a structure for supplementing the floating vertical channel region 140VC to prevent or significantly reduce performance degradation of the semiconductor device 100 due to a floating body effect of the vertical channel region 140VC.

The back gate electrode 135 may include doped polysilicon, metal, conductive metal nitride, metal-semiconductor compound, conductive metal oxide, graphene, carbon nanotube, or combinations thereof. For example, the back gate electrode 135 may be formed of doped polysilicon, Al, Cu, Ti, Ta, Ru, W, Mo, Pt, Ni, Co, TiN, TaN, WN, NbN, TiAl, TiAlN, TiAlC, TaAlC, TiSi, TiSiN, TaSi, TaSiN, RuTiN, NiSi, CoSi, IrOₓ, RuOx, graphene, carbon nanotube, or combinations thereof, but the present disclosure is not limited thereto. The back gate electrode 135 may be formed of a single layer or multiple layers of the aforementioned materials.

In some implementations, the back gate electrode 135 is formed of the same material as the gate electrode 165, but is not limited thereto and may include a different material.

The dielectric structures 132 may extend in the second horizontal Y-direction along both sides of the back gate electrode 135 on the lower insulating layers 101.

In some implementations, the dielectric structures 132 include a first dielectric structure 132_1 disposed on one side of the back gate electrode 135, and a second dielectric structure 132_2 disposed on the other side opposite to the one side of the back gate electrode 135. The first dielectric structure 132_1 includes a portion disposed between the back gate electrode 135 and the first vertical patterns 140_1, and the second dielectric structure 132_2 includes a portion disposed between the back gate electrode 135 and the second vertical patterns 140_2.

The dielectric structures 132 may be disposed between the back gate electrode 135 and the vertical patterns 140 to space the back gate electrode 135 and the vertical patterns 140 apart.

The dielectric structures 132 may include a material different from a material of the gate dielectric layer 162. The dielectric structures 132 may include a material having a lower dielectric constant than a dielectric constant of the gate dielectric layer 162.

In some implementations, each of the dielectric structures 132 include an air gap 132_AG and a first spacer 132_S1.

The air gap 132_AG may extend in the vertical direction Z between the vertical channel region 140VC and the back gate electrode 135. A space between the back gate electrode 135 and the vertical pattern may define the air gap 132_AG. For example, a first space surrounded by the first spacer 132_s1, the back gate electrode 135, and the first layer 137a inside the auxiliary structure 137 may define a first air gap 132_AG. A second space surrounded by the first spacer 132_s1, the back gate electrode 135, and the first layer 137a inside the auxiliary structure 137 may define a second air gap 132_AG. As the back gate structure 130 includes the air gap 132_AG, as opposed to another gate dielectric layer 162 (which has a higher dielectric constant), the distance between the vertical channel region 140VC and the back gate electrode 135 can be relatively narrowed while still achieving the same amount of dielectric shielding from using another, thicker gate dielectric layer 162. The narrowed distance between the vertical channel region 140VC and the back gate electrode 135 can allow high integration and prevent deterioration of characteristics of the semiconductor device 100. For example, the characteristic deterioration may mean that as the distance between the back gate electrode 135 and the vertical channel region 140VC decreases, the controllability of the gate electrode 165 on the vertical channel region 140VC may decrease and the parasitic capacitance between the back gate electrode 135 and the vertical channel region 140VC may increase. Since the air gap 132_AG has a lower dielectric constant than a dielectric constant of the gate dielectric layer 162, the stability of the gate electrode 165 may not be deteriorated while having a relatively small thickness. Accordingly, the semiconductor device 100 can have improved electrical characteristics while obtaining high integration.

In some implementations, an upper surface of the first source/drain region 140SD1 of each of the vertical patterns 140 are on the same or on a lower height than a lower surface of the air gap 132_AG.

In some implementations, a lower surface of the second source/drain region 140SD2 of each of the vertical patterns 140 are disposed at the same height as or higher than the upper surface of the air gap 132_AG.

The first spacer 132_S1 may define at least one surface of the air gap 132_AG to define at least one surface; for example, one side surface and an upper surface of the air gap 132_AG. The other side surface of the air gap 132_AG opposite to the one side surface may be defined by the back gate electrode 135.

In some implementations, the first spacer 132_S1 includes a vertical extension portion 132_S1v extending between the air gap 132_AG and the vertical patterns 140, and a horizontal extension portion 132_S1h extending from an upper end of the vertical extension portion 132_S1v toward the back gate electrode 135. The horizontal extension portion 132_S1h may contact the back gate electrode 135.

The first spacer 132_S1 may include a material different from a material of the gate dielectric layer 162. The first spacer 132_S1 may include at least one of SiO, SiN, SiOC, SiON, SiCN, SiOCN, SiOCH, and SiOF.

In some implementations, the thickness of the first spacer 132_S1 is smaller than the thickness of the air gap 132_AG or the thickness of the gate dielectric layer 162, but the present disclosure is not limited thereto.

The first auxiliary structure 136 may be disposed on the back gate electrode 135 and the dielectric structures 132. The first auxiliary structure 136 may be disposed between the upper insulating layers 107 and the dielectric structures 132 to physically separate the upper insulating layers 107 from the dielectric structures 132. The first auxiliary structure 136 may define an upper surface of each of the dielectric structures 132. An upper surface of the first auxiliary structure 136 may be disposed at substantially the same height as an upper surface of the gate dielectric layer 162.

The vertical patterns 140 may include portions extending along the side surfaces of the dielectric structures 132_1 and 132_2 and onto the side surface of the first auxiliary structure 136. The side surfaces of the dielectric structures 132_1 and 132_2 and the side surface of the first auxiliary structure 136 may be substantially coplanar.

The first auxiliary structure 136 may include an insulating structure such as silicon oxide, silicon nitride, silicon oxynitride, or silicon carbonitride.

The second auxiliary structure 137 may be disposed below the back gate electrode 135. The second auxiliary structure 137 may be disposed between the bit line structure 110 and the back gate electrode 135.

The second auxiliary structure 137 may define a lower surface of the air gap 132_AG. The upper surface of the second auxiliary structure 137 may include a first surface in contact with the lower surface of the back gate electrode 135 and a second surface in contact with the lower surface of the air gap 132_AG.

In some implementations, the first spacer 132_S1 extends between the second auxiliary structure 137 and the vertical patterns 140, but the present disclosure is not limited thereto.

In some implementations, the second auxiliary structure 137 includes a first layer 137a extending downward alongside surfaces of the vertical patterns 140 while covering a lower surface of the back gate electrode 135 and a lower surface of the air gap 132_AG, and a second layer 137b filling between the first layer 137a and the bit line structure 110 or between the first layer 137a and the lower insulating layers 101. The first layer 137a may have a conformal thickness. The first and second layers 137a and 137b of the second auxiliary structure 137 may be formed of an insulating material. The first layer 137a and the second layer 137b may include different insulating materials. For example, the first layer 137a may be at least one of SiN, SiBN, and SiCN, and the second layer 137b may be SiOx. As the second auxiliary structure 137 includes the first layer 137a and the second layer 137b, a lower surface of the air gap 132_AG may be defined to secure a relatively larger space of the air gap 132_AG. However, the type, number of layers, and thickness of the material constituting the second auxiliary structure 137 may be variously changed.

The front gate structures 160 may extend in the second horizontal Y-direction on both sides of the back gate structure 130. The front gate structures 160 may be spaced apart from each other in the first horizontal direction X and extend in parallel.

The front gate structures 160 may include a first front gate structure 160_1 extending in the second horizontal direction Y and surrounding at least one side of the first vertical patterns 140_1, and a second front gate structure 160_2 spaced apart from the first front gate structure 160_1 in the first horizontal direction X, extending in the second horizontal direction Y, and surrounding at least one side of the second vertical patterns 140_2.

Each of the front gate structures 160 may include a gate dielectric layer 162, a gate electrode 165, and a gate capping layer 166. The first front gate structure 160_1 may include a first gate dielectric layer 162_1, a first gate electrode 165_1, and a first gate capping layer 166_1, and the second front gate structure 160_2 may include a second gate dielectric layer 162_2, a second gate electrode 165_2, and a second gate capping layer 166_2.

The gate dielectric layer 162 may be disposed between the gate electrode 165 and the vertical patterns 140, on the lower insulating layers 101.

In some implementations, the gate dielectric layer 162 may be disposed to conformally cover a side surface of the back gate structure 130 and side surfaces of the vertical patterns 140 disposed on the side surface of the back gate structure. In some implementations, the first gate dielectric layer 162_1 may be disposed to cover one side of the back gate structure 130 and side surfaces of the first vertical patterns 140_1 protruding from the side of the back gate structure 130.

In some implementations, the gate dielectric layer 162 has substantially the same length as the vertical patterns 140 in the vertical direction (Z). For example, the gate dielectric layer 162 may have a lower surface in contact with the upper surface of the bit line structure 110, and an upper surface in contact with the lower surfaces of the upper insulating layers 107, and the length of the gate dielectric layer 162 may indicate a distance between the lower surface and the upper surface of the gate dielectric layer 162.

In the vertical direction Z, the length of the gate dielectric layer 162 and/or the length of the vertical patterns 140 may be greater than the length of the air gap 132_AG.

The gate dielectric layer 162 may include at least one of silicon oxide and a high-κ dielectric. The high-κ dielectric may include a metal oxide or a metal oxynitride. For example, the high dielectric material may be formed of HfO2, HfSiO, HfSiON, HfTaO, HfTiO, HfZrO, ZrO2, Al2O3, or combinations thereof, but the present disclosure is not limited thereto. The gate dielectric layer 162 may be formed of a single layer or multiple layers of the materials described above.

The gate electrode 165 may be disposed on at least one side of the gate dielectric layer 162 on the lower insulating layers 101. The gate electrode 165 may be spaced apart from the vertical patterns 140 by the gate dielectric layer 162. In some implementations, the first gate electrode 165_1 is spaced apart from the first vertical patterns 140_1 by the first gate dielectric layer 162_1.

In some implementations, the gate electrode 165 alternately includes a portion having a first width in the first horizontal direction (X), and a portion having a second width greater than the first width, and extends in the second horizontal direction (Y), forming a structure of vertical patterns 140 intermittently extending on the side surface of the back gate structure 130 with the gate dielectric layer 162 conformally covering the same. For example, as the gate electrode 165 can include one side extending in the second horizontal direction (Y-direction) and the other side facing the one side and in contact with the gate dielectric layer 162, portions having the first width and the second width may be alternately repeated.

In some implementations, the gate electrode 165 is disposed to surround three surfaces of the vertical pattern 140.

The gate electrode 165 may have a length shorter than the length of the gate dielectric layer 162 in the vertical direction Z or the length of each of the vertical patterns 140. The gate electrode 165 may be spaced apart from the lower insulating layers 101, and the intermediate insulating layer 103 may fill a space between the lower insulating layers 101 and the gate electrode 165. Also, the gate electrode 165 may be spaced apart from the upper insulating layers 107, and the gate capping layer 166 may be disposed between the upper insulating layers 107 and the gate electrode 165. This can prevent the gate electrode 165 from overlapping with the first and second source/drain regions 140SD1 and 140SD2 in the horizontal direction perpendicular to the vertical direction Z.

The gate electrode 165 may include doped polysilicon, metal, conductive metal nitride, metal-semiconductor compound, conductive metal oxide, conductive graphene, carbon nanotube, or combinations thereof. For example, the gate electrode 165 may be formed of doped polysilicon, Al, Cu, Ti, Ta, Ru, W, Mo, Pt, Ni, Co, TiN, TaN, WN, NbN, TiAl, TiAlN, TiSi, TiSiN., TaSi, TaSiN, RuTiN, NiSi, CoSi, IrOₓ, RuOx, graphene, carbon nanotubes, or combinations thereof, but the present disclosure is not limited thereto. The gate electrode 165 may include a single layer or multiple layers of the aforementioned materials.

The gate capping layer 166 may be disposed on the gate electrode 165. The gate capping layer 166 may be disposed to extend along at least one side of the gate dielectric layer 162. In some implementations, the gate capping layer 166 completely overlaps the gate electrode 165 in the vertical direction (Z direction). In some implementations, the first gate capping layer 166_1 extends along at least one side of the first gate dielectric layer 162_1 on the first gate electrode 165_1.

The gate capping layer 166 may include an insulating material such as silicon oxide, silicon nitride, silicon oxynitride (SiON), or silicon carbonitride (SiCN). In some implementations, the gate capping layer 166 includes a material different from a material of the intermediate insulating layer 103. The gate capping layer 166 may include, for example, silicon nitride.

Referring to FIG. 3, each of the first vertical patterns 140_1 may have a first side surface 140S1 and a second side surface 140S2 opposite to the first side surface 140S1. The first front gate structure 160_1 may face the first side surface 140S1, and the back gate structure 130 may face the second side surface 140S2. The first gate electrode 165_1 is disposed on the first side surface 140S1, and the first gate dielectric layer 162_1 may include a portion disposed between the first vertical patterns 140_1 and the first gate electrode 165_1. The back gate electrode 135 may be disposed on the second side surface 140S2, and the first dielectric structure 132_1 may include a portion disposed between the first vertical patterns 140_1 and the back gate electrode 135. The first dielectric structure 132_1 may contact the second side surface 140S2 of the first vertical patterns 140_1 and the side surface of the back gate electrode 135 facing the second side surface 140S2, respectively.

Each of the second vertical patterns 140_2 may have a third side surface 140S3 and a fourth side surface 140S4 opposing the third side surface 140S3. The second front gate structure 160_2 may face the third side surface 140S3, and the back gate structure 130 may face the fourth side surface 140S4. The second gate electrode 165_2 is disposed to face the third side surface 140S3, and the second gate dielectric layer 162_2 includes a portion disposed between the second vertical patterns 140_2 and the second gate electrode 165_2. The back gate electrode 135 may be disposed to face the fourth side surface 140S4, and the second dielectric structure 132_2 may include a portion disposed between the second vertical patterns 140_2 and the back gate electrode 135. The second dielectric structure 132_2 may contact the fourth side surface 140S4 of the second vertical patterns 140_2 and the side surface of the back gate electrode 135 facing the fourth side surface 140S4, respectively.

The intermediate insulating layer 103 may cover side surfaces of the line structures 120 together with upper surfaces of the bit line structures 110 and the lower insulating layers 101. The intermediate insulating layer 103 may include an insulating material such as silicon oxide, silicon nitride, silicon oxynitride (SiON), or silicon carbonitride (SiCN).

The upper insulating layers 107 may cover the upper surfaces of the line structures 120 and the upper surfaces of the intermediate insulating layer 103, on the line structures 120 and the intermediate insulating layer 103. The upper insulating layers 107 may include an insulating material such as silicon oxide, silicon nitride, silicon oxynitride (SiON), or silicon carbonitride (SiCN).

In some implementations, the upper insulating layers 107 include first to third upper insulating layers 107a, 107b, and 107c that are sequentially stacked. For example, the second upper insulating layer 107b may include silicon oxide, and the third upper insulating layer 107c may include silicon nitride. However, the number of layers and the type of material of the upper insulating layers 107 are not limited thereto and may be variously changed.

The contact patterns 170 may pass through the upper insulating layers 107 to come into contact with the vertical patterns 140 to be electrically connected to the vertical patterns 140. The contact patterns 170 may contact the second source/drain regions 140SD2 of the vertical patterns 140. The contact patterns 170 may electrically connect the vertical patterns 140 and the information storage structure 180.

The lower surfaces of the contact patterns 170 are illustrated as being in contact with the vertical patterns 140 and the gate dielectric layer 162, but in some implementations, the lower surfaces of the contact patterns 170 are in contact with the gate capping layer 166 and/or the first auxiliary structure 136.

The contact patterns 170 may be formed of a conductive material, for example, doped monocrystalline silicon, doped polycrystalline silicon, metal, conductive metal nitride, metal-semiconductor compound, conductive metal oxide, conductive graphene, carbon nanotubes, or combinations thereof. In some implementations, the contact patterns 170 may include first to fourth contact layers 170a, 170b, 170c, and 170d that are sequentially stacked. For example, the first contact layer 170a comprises doped monocrystalline silicon, the second contact layer 170b comprises doped polycrystalline silicon, the third contact layer 170c comprises a silicide material, and the fourth contact layer 170d may include a metal. However, the number of layers and the type of material of the contact patterns 170 may be variously changed.

The information storage structures 180 may include first electrodes 182 electrically connected to the contact patterns 170, a second electrode 186 covering the first electrodes 182, and a dielectric layer 184 between the first electrodes 182 and the second electrode 186.

In some implementations, the information storage structures 180 are capacitors for storing information in a DRAM. For example, the dielectric layer 184 of the information storage structures 180 may be a capacitor dielectric layer of a DRAM, and the dielectric layer 184 may include a high dielectric, silicon oxide, silicon nitride, silicon oxynitride, or combinations thereof.

In some implementations, the information storage structures 180 are structures for storing information in a memory other than a DRAM. For example, the dielectric layer 184 of the information storage structures 180 may be a capacitor dielectric layer of a ferroelectric memory (FeRAM). In this case, the dielectric layer 184 may be a ferroelectric layer capable of recording data using a polarization state. The ferroelectric layer may also include a lower dielectric layer comprising at least one of silicon oxide or a high-κ dielectric, and a ferroelectric layer disposed on the lower dielectric layer, in another implementation.

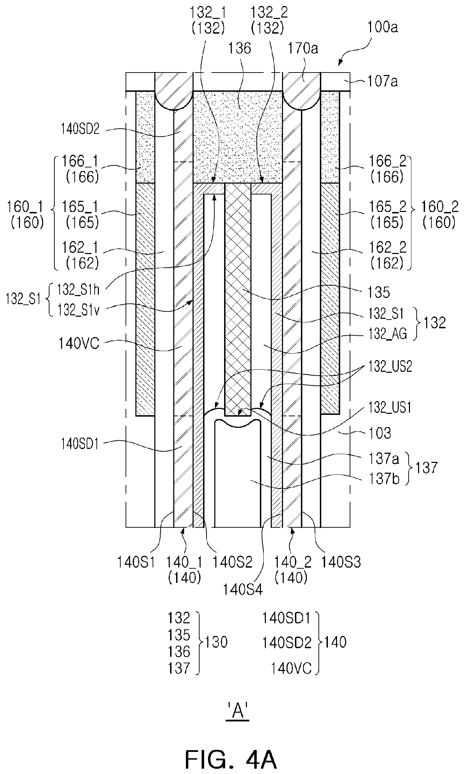

Hereinafter, various modifications of the components of the above-described examples will be described with reference to FIGS. 4A to 7. Various modifications of the components of the above-described examples to be described below will be mainly described with reference to the component being modified or the component being replaced. In addition, the components that may be modified or replaced described below are described with reference to the following drawings, but the components that may be modified or replaced are combined with each other, or combined with the components described above to configure a semiconductor device according to an example of the present disclosure.

FIGS. 4A to 4E are partially enlarged cross-sectional views of examples of semiconductor devices. FIGS. 4A to 4E are enlarged views of an area corresponding to area 'A' of FIG. 2.

Referring to FIG. 4A, in a semiconductor device 100a, the upper surface of the second auxiliary structure 137 may include a first surface 137_US1 in contact with the lower surface of the back gate electrode 135, and a second surface 137_US2 in contact with the lower surface of the air gap 132_AG. A lower surface of the air gap 132_AG may be defined by a second surface 137_US2. The second surface 137_US2 may be located at a height higher than a height of the first surface 137 _US1. This may be because the first layer 137a of the second auxiliary structure 137 partially extends between the back gate electrode 135 and the first spacer 132_S1 to form the second surface 137_US2. Accordingly, the first layer 137a may extend from the lower surface of the back gate electrode 135 to cover a portion of the side surface.

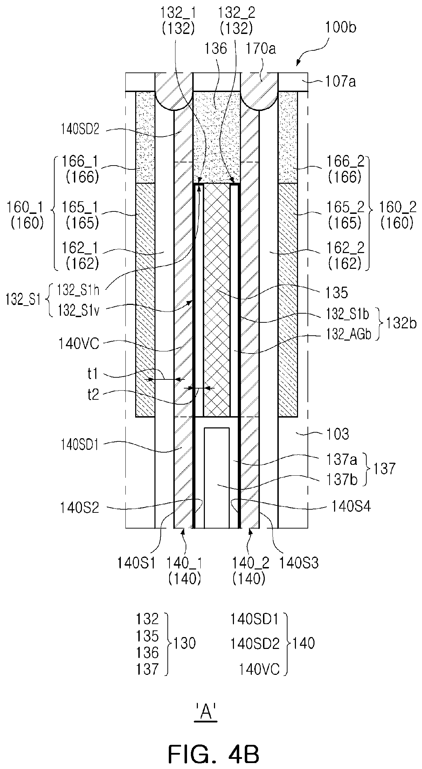

Referring to FIG. 4B, in a semiconductor device 100b, a first thickness t1 of the gate dielectric layer 162 may be greater than a second thickness t2 of each of the dielectric structures 132b.

The sum of the thickness of the first spacer 132_S1b and the thickness of the air gap 132_AGb may be smaller than the thickness of the gate dielectric layer 162.

As the dielectric structures 132b include the air gap 132_AGb having a lower permittivity than the gate dielectric layer 162, the dielectric structures 132b may be formed to have a thickness smaller than the first thickness t1 while still achieving the same amount of dielectric shielding as if having the first thickness t1 and the permittivity of the gate dielectric layer 162, thereby providing a highly-integrated semiconductor device 100b.

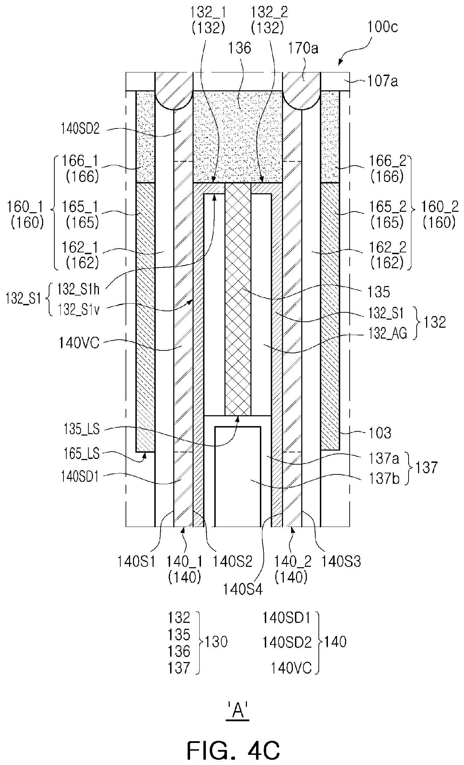

Referring to FIG. 4C, a semiconductor device 100c may have a gate electrode 165 structure different from the structure of FIG. 3.

The lower surface 165_LS of the gate electrode 165 may be disposed at a lower height than the lower surface 135_LS of the back gate electrode 135. In this case, the lower surface 165_LS of the gate electrode 165 may be disposed at a height lower than a height of the upper surface of the second auxiliary structure 137. In some implementations, the upper surface of the gate electrode 165 and the upper surface of the back gate electrode 135 are disposed at substantially the same height, but the present disclosure is not limited thereto.

In the vertical direction Z, the length of the gate electrode 165 may be longer than the length of the back gate electrode 135. Accordingly, the stability of the gate electrode 165 with respect to the vertical channel region 140VC may be improved.

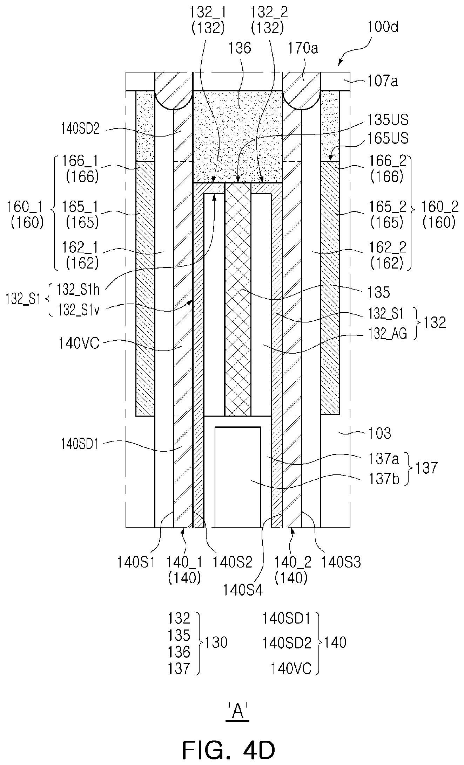

Referring to FIG. 4D, a semiconductor device 100d may have a gate electrode 165 structure different from the structure of FIG. 3.

The upper surface 165_US of the gate electrode 165 may be disposed at a height higher than a height of the upper surface 135_US of the back gate electrode 135. In some implementations, the lower surface of the gate electrode 165 and the lower surface of the back gate electrode 135 are disposed at substantially the same height, but the present disclosure is not limited thereto.

In the vertical direction Z, the length of the gate electrode 165 may be longer than the length of the back gate electrode 135. Accordingly, the stability of the gate electrode 165 with respect to the vertical channel region 140VC may be improved.

The upper surface of the first auxiliary structure 136 and the upper surface of the gate capping layer 166 are located at substantially the same height, but the lower surface of the first auxiliary structure 136 may be located at a lower height than the lower surface of the gate capping layer 166. The gate capping layer 166 and the first auxiliary structure 136 are formed through a separate process, and may thus have lower surfaces of different heights.

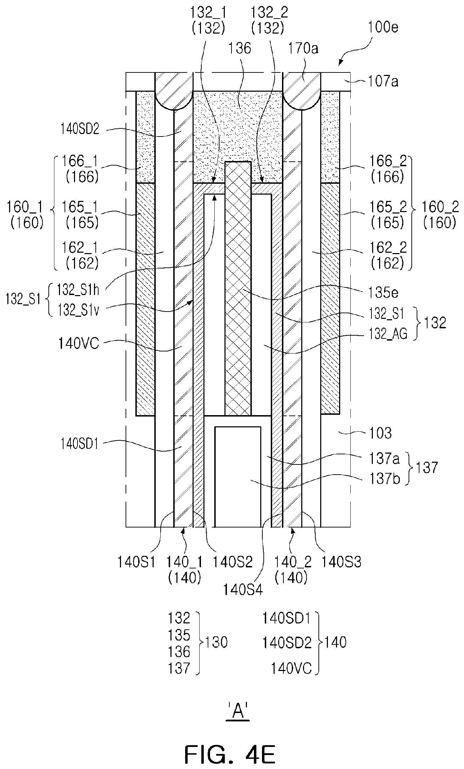

Referring to FIG. 4E, a semiconductor device 100e may have a structure of the back gate electrode 135e different from the structure of FIG. 3.

The upper end of the back gate electrode 135e may extend into the first auxiliary structure 136 by penetrating through a portion of the lower surface of the first auxiliary structure 136. This may be because a portion of the first auxiliary structure 136 is recessed in a process of forming a contact hole corresponding to the back gate electrode 135e. Accordingly, the upper surface of the back gate electrode 135e may be disposed at a height higher than a height of the upper surface of the dielectric structures 132.

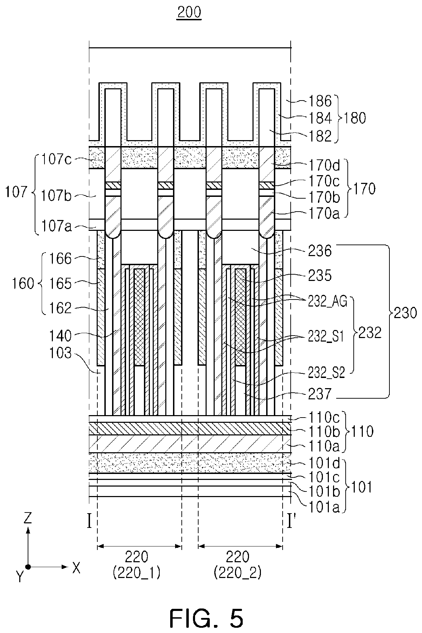

FIG. 5 is a schematic cross-sectional view of an example of a semiconductor device. FIG. 5 illustrates a region corresponding to a cross-section taken along line I-I' of FIG. 1.

Referring to FIG. 5, a semiconductor device 200 may include line structures 220 different from those of the semiconductor device 100 of FIG. 2.

Each of the line structures 220 may include a back gate structure 230, vertical patterns 140 intermittently extending in the second horizontal Y-direction on both sides of the back gate structure 230, and front gate structures 160 extending along at least one side of the vertical patterns 140 on both sides of the back gate structure 230.

The back gate structure 230 may include dielectric structures 232 disposed on both sides of the back gate electrode 235.

Each of the dielectric structures 232 may include an air gap 232_AG, a first spacer 232_S1, and a second spacer 232_S2. The air gap 232_AG and the first spacer 232_S1 may have the same or similar characteristics as those described with reference to FIG. 2.

The second spacer 232_S2 may be disposed between the air gap 232_AG and the back gate electrode 235 to define one side of the air gap 232_AG. The second spacer 232_S2 may extend along a side surface of the back gate electrode 235 to cover an upper surface of the back gate electrode. The second spacer 232_S2 may contact the horizontal extension portion of the first spacer 232_S1.

The second spacer 232_S2 may include at least one of SiO, SiN, SiOC, SiON, SiCN, SiOCN, SiOCH, or SiOF. The second spacer 232_S2 may include the same material as the first spacer 232_S1, but is not limited thereto. For example, the second spacer 232_S2 and the first spacer 232_S1 may include different insulating materials.

In some implementations, the second spacer 232_S2 has substantially the same thickness as the first spacer 232_S1, but the present disclosure is not limited thereto.

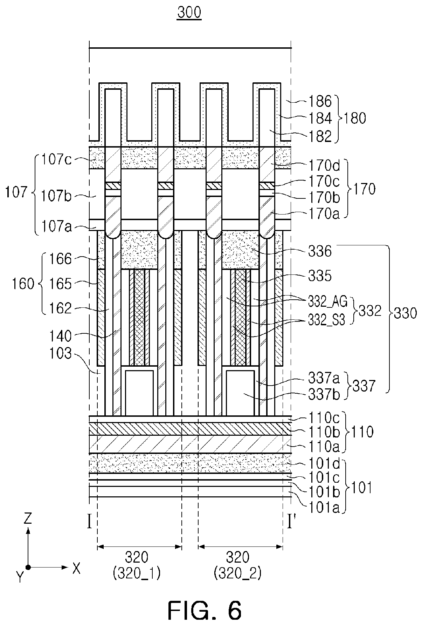

FIG. 6 is a schematic cross-sectional view of an example of a semiconductor device. FIG. 6 illustrates a region corresponding to a cross section taken along line I-I' of FIG. 1.

Referring to FIG. 6, a semiconductor device 300 may include line structures 320 different from those of the semiconductor device 100 of FIG. 2.

Each of the line structures 320 may include a back gate structure 330, vertical patterns 140 intermittently extending in the second horizontal Y-direction on both sides of the back gate structure 330, and front gate structures 160 extending along at least one side of the vertical patterns 140 on both sides of the back gate structure 330.

The back gate structure 330 may include dielectric structures 332 disposed on both sides of the back gate electrode 335.

Each of the dielectric structures 332 may include an air gap 332_AG and a third spacer 332_S3. The first spacer 232_S1 and/or the second spacer 232_S2 may be omitted.

The third spacer 332_S3 may be disposed between the air gap 332_AG and the back gate electrode 335 to define one side of the air gap 332_AG. The third spacer 332_S3 may extend along a side surface of the back gate electrode 335 on the second auxiliary structure 137. The second auxiliary structure 137may define a lower surface of the air gap 332_AG.

The third spacer 332_S3 may include at least one of SiO, SiN, SiOC, SiON, SiCN, SiOCN, SiOCH, or SiOF.

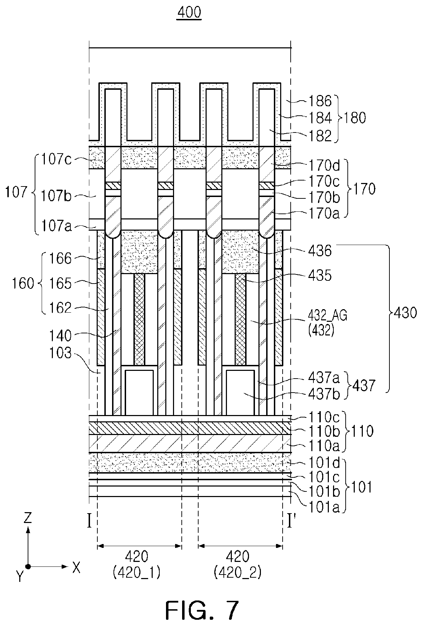

FIG. 7 is a schematic cross-sectional view of an example of a semiconductor device. FIG. 7 illustrates a region corresponding to a cross section taken along line I-I' of FIG. 1.

Referring to FIG. 7, a semiconductor device 400 may include line structures 420 different from those of the semiconductor device 100 of FIG. 2.

Each of the line structures 420 may include a back gate structure 430, vertical patterns 140 intermittently extending in the second horizontal Y-direction on both sides of the back gate structure 430, and front gate structures 160 extending along at least one side of the vertical patterns 140 on both sides of the back gate structure 430.

The back gate structure 430 may include dielectric structures 432 disposed on both sides of the back gate electrode 435.

Each of the dielectric structures 432 may include only an air gap 432_AG. For example, the first to third spacers 232_S1, 232_S2, and 332_S3 may be omitted. The air gap 432_AG may be defined by the back gate electrode 435, the vertical patterns 140, the first auxiliary structure 436, and the second auxiliary structure 437.

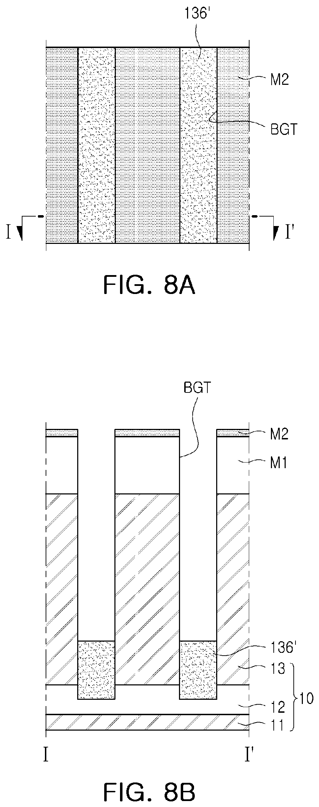

FIGS. 8A to 21B are schematic views illustrating an example of a method of manufacturing a semiconductor device.

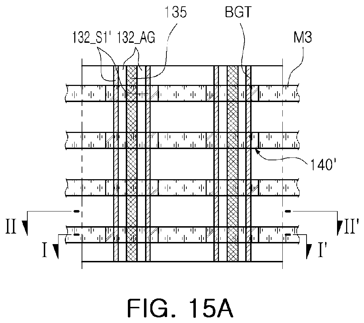

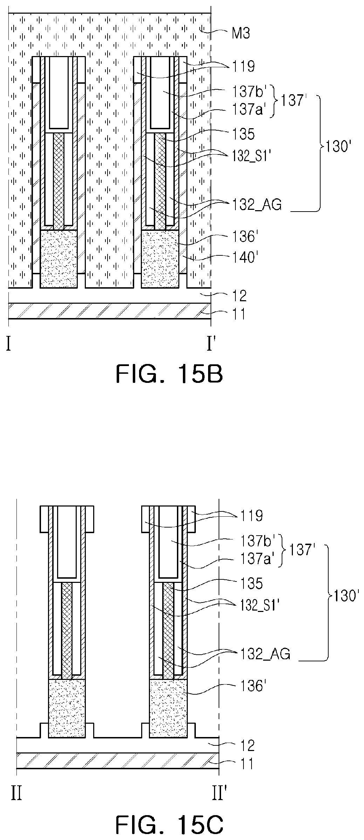

FIGS. 8A, 15A, 16A, 17A, 18A, 19A, 20A, and 21A are plan views illustrating a method of manufacturing a semiconductor device, and FIGS. 8B, 9, 10, 11, 12, 13, 14, 15B, 16B, 17B, 18B, 19B, 20B, and 21B are cross-sectional views illustrating regions corresponding to the cross-section taken along line I-I' of FIG. 1. and FIG. 15C is a cross-sectional view illustrating a region corresponding to a cross-section taken along line II-II' of FIG. 15A.

Referring to FIGS. 8A and 8B, a back gate trench BGT may be formed in the semiconductor substrate 10, and a first auxiliary structure 136' may be formed in the back gate trench BGT.

The semiconductor substrate 10 may be a silicon on insulator (SOI) substrate. The semiconductor substrate 10 may include a lower semiconductor layer 11, an insulating layer 12, and an upper semiconductor layer 13. For example, the upper and lower semiconductor layers 11 and 13 may include single crystal silicon.

An etching process using the first and second masks M1 and M2 may be performed to form the back gate trench BGT penetrating through the upper semiconductor layer 13 and exposing the insulating layer 12. In some implementations, the insulating layer 12 is partially removed through the etching process. The back gate trench BGT may be formed in the form of a line extending in the second horizontal Y-direction.

Next, an insulating material forming the first auxiliary structure 136' is deposited in the back gate trench BGT, a planarization process is performed, and then, the first auxiliary structure 136' may be formed by performing an etch-back process of recessing the insulating material by a predetermined height in the back gate trench BGT. The insulating material may be, for example, silicon nitride. The first auxiliary structure 136' may be a structure defining upper surfaces of the dielectric structures 132 (refer to FIG. 2) formed through a subsequent process.

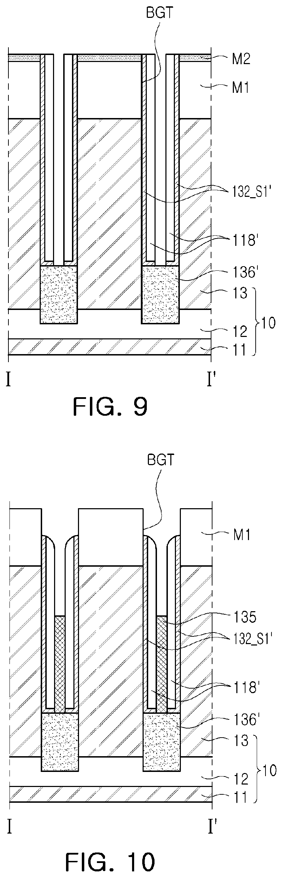

Referring to FIG. 9, first spacers 132_S1' and vertical sacrificial layers 118' may be formed on sidewalls of the back gate trench BGT.

The first material layer forming the first spacers 132_S1' and the second material layer forming the vertical sacrificial layers 118' may be sequentially deposited to conformally cover the upper surface of the first auxiliary structure 136' and the sidewall of the back gate trench BGT. The first material layer may include, for example, SiOC, and the second material layer may include, for example, SiOx. Next, first spacers 132_S1' and vertical sacrificial layers 118' covering both sidewalls of the back gate trench BGT may be formed by performing an anisotropic etching process on the first material layer and the second material layer. The vertical sacrificial layers 118' may include regions in which the air gap 132_AG is formed through a subsequent process. An upper surface of the first auxiliary structure 136' may be partially exposed by the anisotropic etching process.

In this operation, when a portion of the first auxiliary structure 136' is also removed, the semiconductor device 100e of FIG. 4E may be provided through a subsequent process.

Referring to FIG. 10, a back gate electrode 135 may be formed.

The back gate electrode 135 may be formed by depositing a conductive material to fill the back gate trench BGT, performing a planarization process, and then performing an etch back process. The conductive material may include, for example, TiN. The etch-back process may be a process of selectively removing the second mask M2 and the layer including the conductive material from the first mask M1. The height of the back gate electrode 135 may be adjusted through the etch-back process.

In some implementations, when the etch-back process is performed, portions of upper ends of the first spacers 132_S1' and the vertical sacrificial layers 118' are removed together.

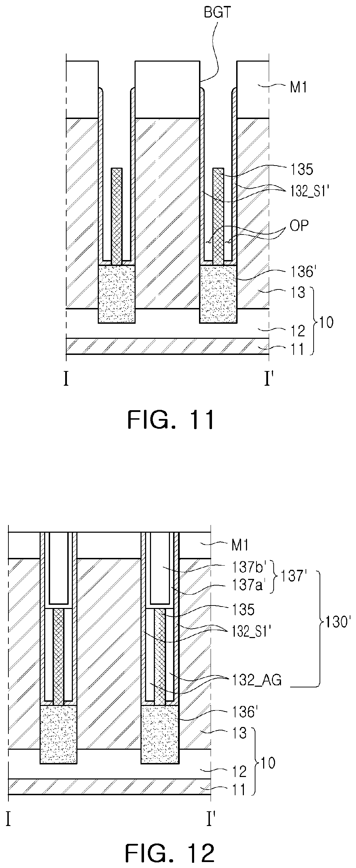

Referring to FIG. 11, openings OP may be formed by removing the vertical sacrificial layers 118'.

The openings OP may be formed by performing an etching process to selectively remove the vertical sacrificial layers 118' from the first spacers 132_S1' and the back gate electrode 135. Each of the openings OP may be a line-shaped opening defined by the first spacers 132_S1' and the back gate electrode 135.

Referring to FIG. 12, air gaps 132_AG and a second preliminary auxiliary structure 137' may be formed.

A first layer 137a' conformally covering the inside of the back gate trench BGT and a second layer 137b' covering the first layer 137a' are formed on the openings OP and the back gate electrode 135. The second preliminary auxiliary structure 137' may be formed by sequentially depositing and performing a planarization process. The first layer 137a' and the second layer 137b' may include different insulating materials from each other. For example, the first layer 137a' may include at least one of SiN, SiBN, and SiCN, and the second layer 137b' may include SiOx. The openings OP having a closed space by the second preliminary auxiliary structure 137' may form air gaps 132_AG. An upper surface of the air gaps 132_AG may be defined by the first layer 137a'.

In this operation, a portion of the first layer 137a' is formed to extend into the openings OP, and as a subsequent process proceeds, the semiconductor device 100a of FIG. 4A may be formed.

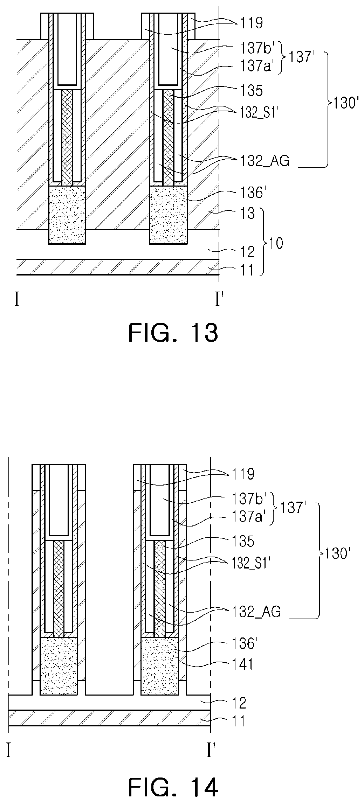

Referring to FIG. 13, the first mask M1 may be removed and a sacrificial spacer 119 may be formed.

The upper semiconductor layer 13 may be exposed by selectively removing the first mask M1 with respect to the second preliminary auxiliary structure 137'. Accordingly, a portion of the side surface of the second preliminary auxiliary structure 137' may be exposed. In some implementations, in the process of removing the first mask M1, a portion of the upper portion of the upper semiconductor layer 13 is also removed.

Next, a material constituting the sacrificial spacer 119 is deposited and an anisotropic etching process is performed to form the sacrificial spacer 119 disposed on the side surface of the second preliminary auxiliary structure 137' on the upper semiconductor layer 13. The sacrificial spacer 119 may contact the upper surface of the upper semiconductor layer 13. The sacrificial spacer 119 may be a mask layer for forming the vertical patterns 140 (FIG. 2) through a subsequent process. The sacrificial spacer 119 may include an insulating material, and the insulating material may include, for example, silicon oxide, silicon nitride, silicon oxynitride, or combinations thereof.

Referring to FIG. 14, the upper semiconductor layer 13 may be patterned using the second preliminary auxiliary structure 137' and the sacrificial spacer 119 as an etch mask to form vertical conductive layers 141.

The upper semiconductor layer 13 may be etched through the patterning to form vertical conductive layers 141 extending in the second horizontal Y-direction on both sides of the preliminary back gate structure 130'. In some implementations, a portion of the insulating layer 12 together with the upper semiconductor layer 13 is removed by a predetermined depth through the patterning, but the present disclosure is not limited thereto.

The vertical conductive layers 141 may be disposed to overlap the sacrificial spacer 119 in the vertical direction (Z). Accordingly, the vertical conductive layers 141 may have substantially the same width as the sacrificial spacer 119 in the first horizontal direction (X).

Referring to FIGS. 15A, 15B, and 15C, a portion of the vertical conductive layers 141 may be removed using the third mask M3 to form vertical patterns 140'.

A third mask M3 may be formed to extend in the first horizontal direction X along the upper portion of the preliminary back gate structure 130', to be spaced apart from each other in the second horizontal Y-direction, and to extend in parallel. The third mask M3 may include, for example, SOH.

Using the third mask M3 as an etch mask, portions of the vertical conductive layers 141 in a region that do not overlap with the third mask M3 in the vertical direction Z are removed to form vertical patterns 140'. Accordingly, the vertical patterns 140' may be in the form of patterns intermittently extending in the second horizontal Y-direction on both sides of the preliminary back gate structure 130'.

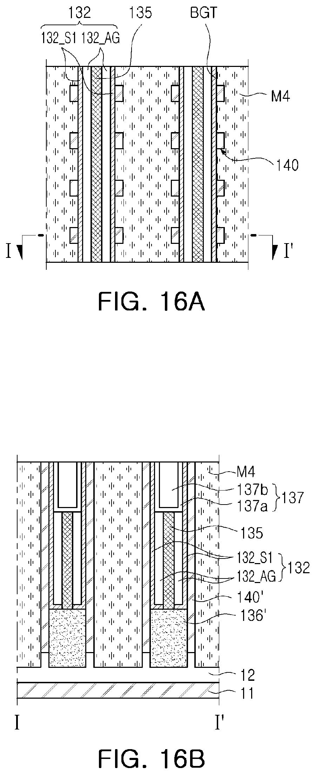

Referring to FIGS. 16A and 16B, the third mask M3 is removed, and the sacrificial spacer 119 and a portion of an upper end of the second preliminary auxiliary structure 137' are removed using the fourth mask M4 to form a second auxiliary structure 137.

The fourth mask M4 may be formed by forming the insulating material layer covering the preliminary back gate structure 130', the vertical patterns 140' and the sacrificial spacer 119 on the insulating layer 12 and then partially removing the insulating material layer to have an upper surface substantially at the same height as the lower surface of the sacrificial spacer 119 through an etch-back process. The insulating material layer may be, for example, SOH. Accordingly, the upper and side surfaces of the sacrificial spacer 119 may be exposed.

Next, by performing an etch-back process to remove a portion of the second preliminary auxiliary structure 137' and the sacrificial spacer 119 to the height of the upper surface of the fourth mask M4, the upper surfaces of the vertical patterns 140' may be exposed.

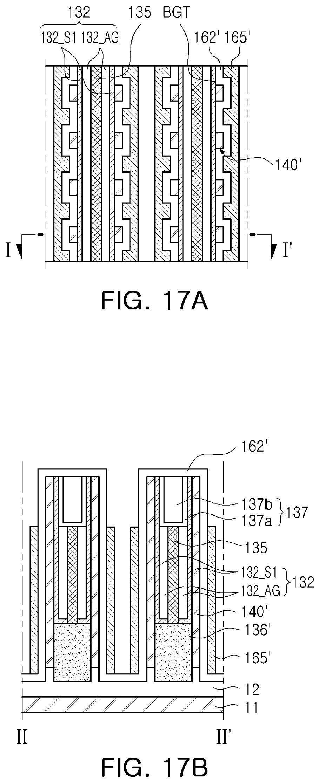

Referring to FIGS. 17A and 17B, a preliminary gate dielectric layer 162' and a preliminary gate electrode 165' may be formed.

The preliminary gate dielectric layer 162' and the preliminary gate electrode 165' are sequentially deposited to conformally cover the upper surface of the insulating layer 12 and the side surfaces of the vertical patterns 140', and the upper surface of the preliminary gate electrode 165' may be adjusted to be lower than the vertical patterns 140' by selectively removing the preliminary gate electrode 165'. Although the upper surface of the preliminary gate electrode 165' is illustrated as being disposed at substantially the same height as the lower surface of the second auxiliary structure 137, the height of the upper surface of the preliminary gate electrode 165' may be variously adjusted.

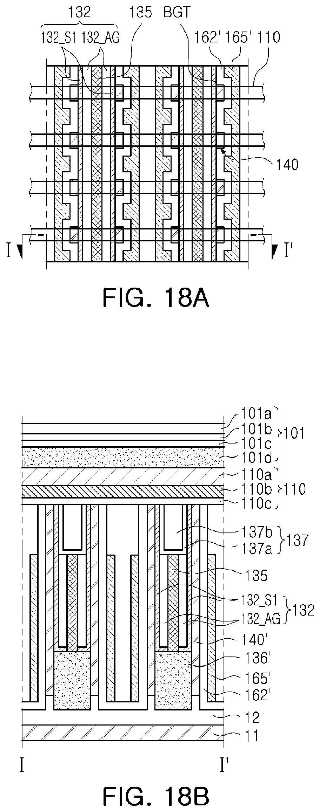

Referring to FIGS. 18A and 18B, the intermediate insulating layer 103, the bit line structure 110, and the lower insulating layers 101 may be sequentially formed.

After depositing the insulating material, an etch-back process may be performed to remove the insulating material and a portion of the preliminary gate dielectric layer 162' to form the intermediate insulating layer 103. The intermediate insulating layer 103 may fill a space between the adjacent preliminary gate electrodes 165'.

The bit line structure 110 extending in the first horizontal direction X may be formed by sequentially depositing a plurality of conductive material layers on the intermediate insulating layer 103 and performing a patterning process. The material and the number of layers constituting the bit line structure 110 are not limited to those illustrated and may be variously changed.

Lower insulating layers 101 may be formed on the bit line structure 110 and the intermediate insulating layer 103. The fourth lower insulating layer 101d which is the lowest insulating layer among the lower insulating layers 101 may cover the upper surface and side surfaces of the bit line structure 110, and the first lower insulating layer 101a which is the uppermost insulating layer among the lower insulating layers 101 may be an adhesive layer for bonding to other structures.

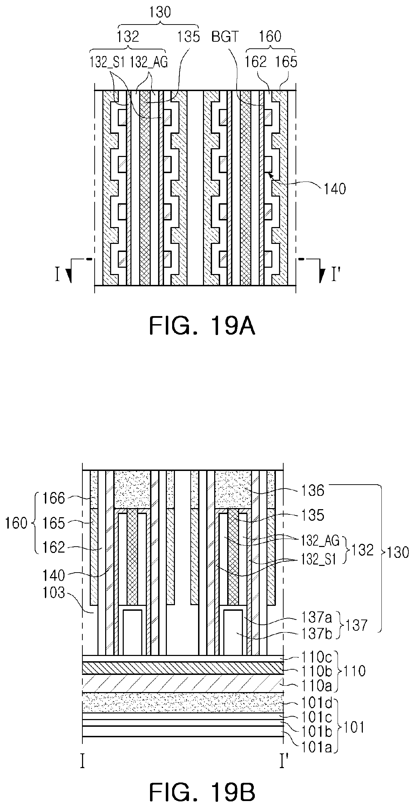

Referring to FIGS. 19A and 19B, a backgrinding process is performed by turning the semiconductor substrate 10 over to form a back gate structure 130, vertical patterns 140, and a gate dielectric layer 162, and a gate electrode 165 and a gate capping layer 166 may be formed.

The semiconductor substrate 10 is turned over, and by performing the backgrinding process of removing a portion of the preliminary gate dielectric layer 162', the first auxiliary structure 136' and the preliminary vertical patterns 140' together with the lower semiconductor layer 11 and the insulating layer 12, the back gate structure 130, the vertical patterns 140, and the preliminary gate dielectric layer 162 may be formed.

Next, the preliminary gate electrode 165' is selectively removed to lower the upper surface height of the preliminary gate electrode 165' to form the gate electrode 165, and by filling an insulating material, for example, silicon nitride in the region in which the preliminary gate electrode 165' has been removed, the gate capping layer 166 may be formed. Accordingly, the front gate structure 160 including the gate dielectric layer 162, the gate electrode 165, and the gate capping layer 166 may be formed.

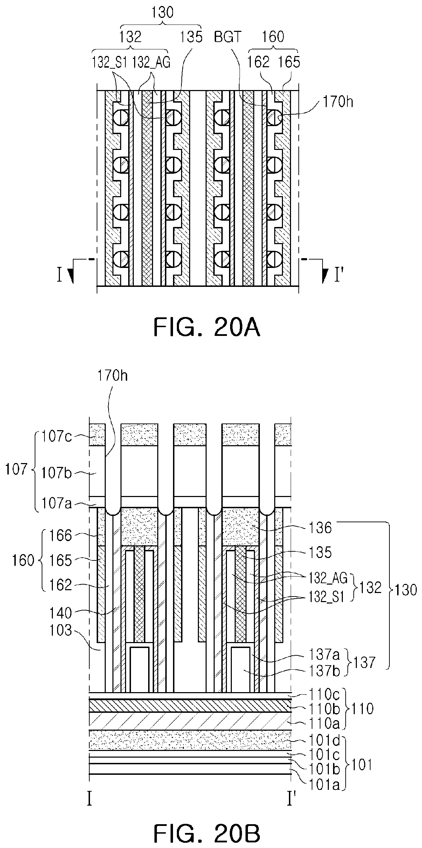

Referring to FIGS. 20A and 20B, the upper insulating layers 107 may be formed, and contact holes 170h passing through the upper insulating layers 107 to expose the upper surfaces of the vertical patterns 140 may be formed.

Upper insulating layers 107 covering the back gate structure 130, the front gate structure 160, the vertical patterns 140, and the intermediate insulating layer 103 may be formed. The upper insulating layers 107 may include first to third upper insulating layers 107a, 107b, and 107c, but the number of the upper insulating layers 107 is not limited thereto.

Next, contact holes 170h exposing the upper surfaces of the vertical patterns 140 may be formed. In a plan view, the contact holes 170h may have a circular shape, but are not limited thereto and may be changed into various shapes such as polygons and ovals.

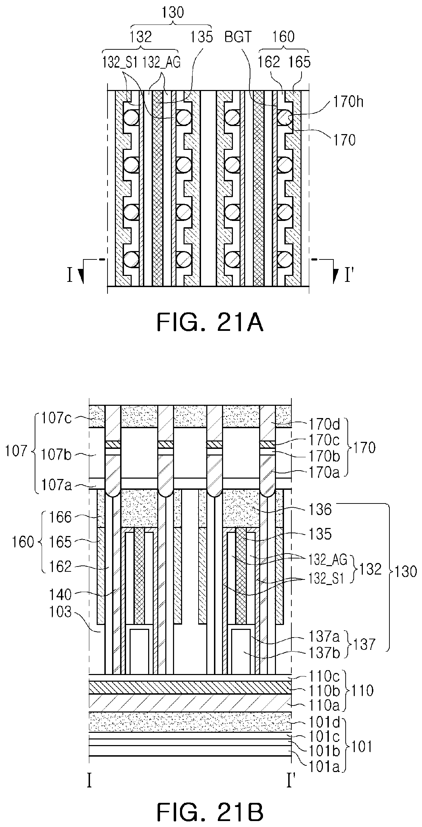

Referring to FIGS. 21A and 21B, contact patterns 170 may be formed in the contact holes 170h.

In some implementations, an epitaxy process is performed from the exposed vertical patterns 140 and a planarization process is performed to form a first contact layer 170a, and second to fourth contact layers 170b, 170c, and 170d are formed above the first contact layer 170a. Each of the contact patterns 170 may be formed by forming the four contact layers 170a, 170b, 170c, and 170d. In the epitaxial process, impurities are implanted together, such that the first contact layer 170a may be a doped semiconductor layer. In addition, the impurities may move to the vertical patterns 140 through the epitaxial process or diffusion in a subsequent process to form a second source/drain region 140SD2 (refer to FIG. 3).

However, the method of manufacturing the contact patterns 170 and the number and material of the layers forming the contact patterns 170 may be variously changed.

Next, referring to FIGS. 2 and 3, the information storage structure 180 including the first electrode 182 electrically connected to the contact patterns 170 may be formed on the upper insulating layers 107.

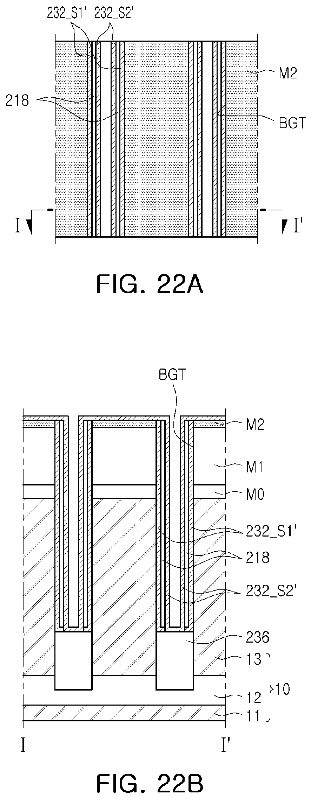

FIGS. 22A to 24 are schematic views illustrating an example of a method of manufacturing a semiconductor device.

FIG. 22A is a plan view illustrating a method of manufacturing a semiconductor device, and FIGS. 22B, 23, and 24 are cross-sectional views illustrating regions corresponding to a cross-section taken along line I-I' of FIG. 1.

Referring to FIGS. 22A and 22B, a back gate trench BGT is formed in the semiconductor substrate 10, a first auxiliary structure 236' is formed in the back gate trench BGT, first preliminary spacers 232_S1' and vertical sacrificial layers 218' may be formed on sidewalls of the back gate trench BGT, and second preliminary spacers 232_S2' may be formed.

After the first preliminary spacers 232_S1' and the vertical sacrificial layers 218' are formed in the same or similar manner to those described with reference to FIGS. 8A to 9, second preliminary spacers 232_S2' may be formed to conformally cover side surfaces of the vertical sacrificial layers 218' and the exposed upper surface of the first auxiliary structure 236'. The second preliminary spacers 232_S2' may include the same material as the first preliminary spacer 232_S1', for example, SiOC, but the present disclosure is not limited thereto.

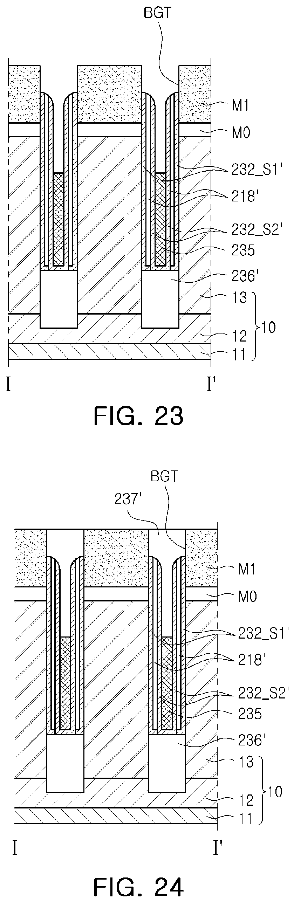

Referring to FIG. 23, a back gate electrode 235 may be formed.

Similar to that described in FIG. 10, a back gate electrode may be formed by depositing a conductive material to fill the back gate trench BGT and then performing a planarization process and an etch back process.

Upper surfaces of the vertical sacrificial layers 218' may be exposed by the planarization process and the etch-back process.

Referring to FIG. 24, air gaps 232_AG and a second auxiliary structure 237' may be formed.

A second auxiliary structure 237' may be formed by removing the vertical sacrificial layers 218' from the exposed upper surfaces of the vertical sacrificial layers 218' and depositing an insulating material, for example, silicon oxide. A closed space is formed by covering an upper surface of a region from which the vertical sacrificial layers 218' have been removed by the second auxiliary structure 237', which may form air gaps 232_AG. For example, the second auxiliary structure 237' may define upper surfaces of the air gaps 232_AG.

Since the distance between the first and second preliminary spacers 232_S1' and 232_S2' or the thickness of the vertical sacrificial layers 218' is relatively small, although the second auxiliary structure 237' is illustrated as being formed of a single layer, the second auxiliary structure 237' may be formed to have a double-layer or multi-layer structure similar to that described with reference to FIG. 12.

Next, the semiconductor device 200 of FIG. 5 may be formed by performing a subsequent process similarly to those described with reference to FIGS. 13 to 21B and FIG. 2.

As set forth above, as a dielectric structure having a structure different from a structure of the gate dielectric layer between the gate electrode and the vertical channel region is disposed between the back gate electrode and the vertical channel region, a semiconductor device having high integration or improved electrical characteristics may be provided. The dielectric structure may include a material having a lower dielectric constant than a dielectric constant of the gate dielectric layer, for example, an air gap, and therefore, the controllability of the back gate electrode with respect to the vertical channel region may be relatively reduced and the parasitic capacitance between the back gate electrode and the vertical channel region may be prevented or reduced. Accordingly, a highly integrated semiconductor device while relatively increasing the stability of the gate electrode for the vertical channel region may be provided.

While examples of implementations have been illustrated and described above, it will be apparent to those skilled in the art that modifications and variations could be made without departing from the scope of the present disclosure as defined by the appended claims.

## Claims

1. A semiconductor device (100) comprising:
a vertical pattern (140) including a first source/drain region (140SD1), a second source/drain region (140SD2) at a height higher than a height of the first source/drain region, and a vertical channel region (140VC) between the first and second source/drain regions;
a front gate structure (160) facing a first side surface of the vertical pattern; and
a back gate structure (130) facing a second side surface of the vertical pattern, the second side surface of the vertical pattern being opposite to the first side surface of the vertical pattern,
wherein the front gate structure includes:
a gate electrode (165) on the first side surface of the vertical pattern; and
a gate dielectric layer (162), wherein at least a portion of the gate dielectric layer is positioned between the vertical pattern and the gate electrode;
wherein the back gate structure includes:
a back gate electrode (135) on the second side surface of the vertical pattern; and
a dielectric structure (132) including a portion between the vertical pattern and the back gate electrode; and
**characterized by** a second auxiliary structure (137) below the back gate electrode,
wherein the dielectric structure includes an air gap (132_AG) within the dielectric structure and wherein the second auxiliary structure defines a lower surface of the air gap.

2. The semiconductor device of claim 1, wherein the dielectric structure comprises a first spacer (132_S1) defining at least one side of the air gap.

3. The semiconductor device of claim 2, wherein the first spacer includes a material different from a material of the gate dielectric layer.

4. The semiconductor device of claim 2 or claim 3, wherein the gate dielectric layer comprises at least one of SiO, HfO₂, HfSiO, HfSiON, HfTaO, HfTiO, HfZrO, ZrO2, or Al₂O₃.

5. The semiconductor device of claim 2 or claim 3, wherein the first spacer comprises at least one of SiO, SiN, SiOC, SiON, SiCN, SiOCN, SiOCH, or SiOF.

6. The semiconductor device of any one of claims 2 - 5, wherein the first spacer includes a vertical extension portion (132_S1v) between the air gap and the vertical pattern and a horizontal extension portion (132_S1h) extending from an upper end of the vertical extension portion toward the back gate electrode,
wherein the horizontal extension portion is in contact with the back gate electrode.

7. The semiconductor device of any one of claims 2 - 6, wherein the dielectric structure includes a second spacer (232_S2) between the air gap and the back gate electrode, the second spacer being in contact with a horizontal extension portion of the first spacer.

8. The semiconductor device of any one of claims 2 - 7, wherein a width of the air gap is greater than a thickness of the first spacer, and
the width of the air gap is a distance between both sides of the air gap.

9. The semiconductor device of any preceding claim, wherein the back gate structure includes a first auxiliary structure (136) on the back gate electrode and the dielectric structure, and
the vertical pattern has a portion extending on a side surface of the first auxiliary structure along a side surface of the dielectric structure.

10. The semiconductor device of claim 9, wherein the front gate structure comprises a gate capping layer (166) on the gate electrode, and
a lower surface of the first auxiliary structure is at substantially a same height as or at a height lower than a lower surface of the gate capping layer.

11. The semiconductor device of any preceding claim, wherein the second auxiliary structure includes:
a first layer (137a) covering a lower surface of the back gate electrode and the lower surface of the air gap and extending downward along a side surface of the vertical pattern; and
a second layer (137b) that fills an inside of the first layer.

12. The semiconductor device of any preceding claim, wherein an upper surface of the second auxiliary structure has a first surface in contact with the back gate electrode, and a second surface defining the air gap, the second surface being disposed at a height higher than the first surface.

13. The semiconductor device of any preceding claim, wherein a lower surface of the gate electrode is at a height lower than an upper surface of the second auxiliary structure.

14. The semiconductor device of any preceding claim, wherein an upper surface of the first source/drain region of the vertical pattern is on a same height as or at a height lower than a lower end of the air gap.

## Patentansprüche

1. Halbleitervorrichtung (100), umfassend:
ein vertikales Muster (140), das einen ersten Source-/Drain-Bereich (140SD1), einen zweiten Source-/Drain-Bereich (140SD2) in einer Höhe, die größer ist als die Höhe des einen ersten Source-/Drain-Bereichs und einen vertikalen Kanalbereich (140VC) zwischen dem ersten und zweiten Source-/Drain-Bereich beinhaltet;
eine vordere Gate-Struktur (160), die einer ersten Seitenoberfläche des vertikalen Musters zugewandt ist; und
eine hintere Gate-Struktur (130), die einer zweiten Seitenoberfläche des vertikalen Musters zugewandt ist, wobei die zweite Seitenoberfläche des vertikalen Musters der ersten Seitenoberfläche des vertikalen Musters gegenüberliegt,
wobei die vordere Gate-Struktur beinhaltet:
eine Gate-Elektrode (165) auf der ersten Seitenoberfläche des vertikalen Musters; und
eine Gate-Dielektrikumschicht (162), wobei mindestens ein Abschnitt der Gate-Dielektrikumschicht zwischen dem vertikalen Muster und der Gate-Elektrode positioniert ist;
wobei die hintere Gate-Struktur beinhaltet:
eine hintere Gate-Elektrode (135) auf der zweiten Seitenoberfläche des vertikalen Musters; und
eine dielektrische Struktur (132), die einen Abschnitt zwischen dem vertikalen Muster und der hinteren Gate-Elektrode beinhaltet; und
**gekennzeichnet durch** eine zweite Hilfsstruktur (137) unterhalb der hinteren Gate-Elektrode,
wobei die dielektrische Struktur einen Luftspalt (132_AG) innerhalb der dielektrischen Struktur beinhaltet und wobei die zweite Hilfsstruktur eine untere Oberfläche des Luftspalts definiert.

2. Halbleitervorrichtung nach Anspruch 1, wobei die dielektrische Struktur einen ersten Abstandhalter (132_S1) umfasst, der mindestens einer Seite des Luftspalts definiert.

3. Halbleitervorrichtung nach Anspruch 2, wobei der erste Abstandhalter ein verschiedenes Material als ein Material der Gate-Dielektrikumschicht beinhaltet.

4. Halbleitervorrichtung nach Anspruch 2 oder Anspruch 3, wobei die Gate-Dielektrikumschicht mindestens eines von SiO, HfO₂, HfSiO, HfSiON, HfTaO, HfTiO, HfZrO, ZrO2, oder Al₂O₃ umfasst.

5. Halbleitervorrichtung nach Anspruch 2 oder Anspruch 3, wobei der erste Abstandhalter mindestens eines von SiO, SiN, SiOC, SiON, SiCN, SiOCN, SiOCH, oder SiOF umfasst.

6. Halbleitervorrichtung nach einem der Ansprüche 2-5, wobei der erste Abstandhalter einen vertikalen Erstreckungsabschnitt (132_S1v) zwischen dem Luftspalt und dem vertikalen Muster, und einen horizontalen Erstreckungsabschnitt (132_S1h) beinhaltet, der sich von einem oberen Ende des vertikalen Erstreckungsabschnitts in Richtung der hinteren Gate-Elektrode erstreckt,
wobei der horizontale Erstreckungsabschnitt mit der hinteren Gate-Elektrode in Kontakt steht.

7. Halbleitervorrichtung nach einem der Ansprüche 2-6, wobei die dielektrische Struktur einen zweiten Abstandhalter (232_S2) zwischen dem Luftspalt und der hinteren Gate-Elektrode beinhaltet, wobei der zweite Abstandhalter mit einem horizontalen Erstreckungsabschnitt des ersten Abstandhalters in Kontakt steht.

8. Halbleitervorrichtung nach einem der Ansprüche 2-7, wobei eine Breite des Luftspalts größer ist als eine Dicke des ersten Abstandhalters, und
die Breite des Luftspalts ein Abstand zwischen beiden Seiten des Luftspalts ist.

9. Halbleitervorrichtung nach einem vorstehenden Anspruch, wobei die hintere Gate-Struktur eine erste Hilfsstruktur (136) an der hinteren Elektrode und die dielektrische Struktur beinhaltet, und
das vertikale Muster einen Abschnitt aufweist, der sich auf einer Seitenoberfläche der ersten Hilfsstruktur entlang einer Seitenoberfläche der dielektrischen Struktur erstreckt.

10. Halbleitervorrichtung nach Anspruch 9, wobei die vordere Gate-Struktur eine Gate-Deckschicht (166) auf der Gate-Elektrode umfasst, und
eine untere Oberfläche der ersten Hilfsstruktur im Wesentlichen auf gleicher Höhe wie oder niedriger als eine untere Oberfläche der Gate-Deckschicht liegt.

11. Halbleitervorrichtung nach einem vorstehenden Anspruch, wobei die zweite Hilfsstruktur beinhaltet:
eine erste Schicht (137a), die eine untere Oberfläche der hinteren Gate-Elektrode und die untere Oberfläche des Luftspalts bedeckt und sich entlang einer Seitenoberfläche des vertikalen Musters nach unten erstreckt; und
eine zweite Schicht (137b), die ein Inneres der ersten Schicht ausfüllt.

12. Halbleitervorrichtung nach einem vorstehenden Anspruch, wobei eine obere Oberfläche der zweiten Hilfsstruktur eine erste Oberfläche in Kontakt mit der hinteren Gate-Elektrode aufweist, und eine zweite Oberfläche, die den Luftspalt definiert, wobei die zweite Oberfläche auf einer Höhe angeordnet ist, die größer als die erste Oberfläche ist.

13. Halbleitervorrichtung nach einem vorstehenden Anspruch, wobei eine untere Oberfläche der Gate-Elektrode auf einer Höhe liegt, die geringer als eine obere Oberfläche der zweiten Hilfsstruktur ist.

14. Halbleitervorrichtung nach einem vorstehenden Anspruch, wobei eine obere Oberfläche des ersten Source-/Drain-Bereichs des vertikalen Musters auf gleicher Höhe oder auf einer Höhe liegt, die geringer als ein unteres Ende des Luftspalts ist.

## Revendications

1. Dispositif à semi-conducteur (100), comprenant :
un motif vertical (140) incluant une première région de source/drain (140SD1), une seconde région de source/drain (140SD2) à une hauteur supérieure à la hauteur de la première région de source/drain, et une région de canal vertical (140VC) entre les première et seconde régions de source/drain ;
une structure de grille avant (160) faisant face à une première surface latérale du motif vertical ; et
une structure de grille arrière (130) faisant face à une seconde surface latérale du motif vertical, la second surface latérale du motif vertical étant opposée à la première surface latérale du motif vertical,
dans lequel la structure de grille avant inclut :
une électrode de grille (165) sur la première surface latérale du motif vertical ; et
une couche diélectrique de grille (162), dans lequel au moins une partie de la couche diélectrique de grille est positionnée entre le motif vertical et l'électrode de grille ;
dans lequel la structure de grille arrière inclut :
une électrode de grille arrière (135) sur la seconde surface latérale du motif vertical ; et
une structure diélectrique (132) incluant une portion située entre le motif vertical et l'électrode de grille arrière ; et
**caractérisé par** une seconde structure auxiliaire (137) sous l'électrode de grille arrière,
dans lequel la structure diélectrique inclut un entrefer (132_AG) dans la structure diélectrique, et dans lequel la seconde structure auxiliaire définit une surface inférieure de l'entrefer.

2. Dispositif à semi-conducteur selon la revendication 1, dans lequel la structure diélectrique comprend un premier espaceur (132_S1) définissant au moins un côté de l'entrefer.

3. Dispositif à semi-conducteur selon la revendication 2, dans lequel le premier espaceur inclut un matériau différent d'un matériau de la couche diélectrique de grille.

4. Dispositif à semi-conducteur selon la revendication 2 ou la revendication 3, dans lequel la couche diélectrique de grille comprend au moins un parmi : SiO, HfO₂, HfSiO, HfSiON, HfTaO, HfTiO, HfZrO, ZrO2, ou Al₂O₃.

5. Dispositif à semi-conducteur selon la revendication 2 ou la revendication 3, dans lequel le premier espaceur comprend au moins un parmi : SiO, SiN, SiOC, SiON, SiCN, SiOCN, SiOCH ou SiOF.

6. Dispositif à semi-conducteur selon l'une quelconque des revendications 2-5, dans lequel le premier espaceur inclut une partie d'extension verticale (132_S1v) entre l'entrefer et le motif vertical et une partie d'extension horizontale (132_S1h) s'étendant depuis une extrémité supérieure de la partie d'extension verticale vers l'électrode de grille arrière,
dans lequel la partie d'extension horizontale est en contact avec l'électrode de grille arrière.

7. Dispositif à semi-conducteur selon l'une quelconque des revendications 2-6, dans lequel la structure diélectrique inclut un second espaceur (232_S2) entre l'entrefer et l'électrode de grille arrière, le second espaceur étant en contact avec une partie d'extension horizontale du premier espaceur.

8. Dispositif à semi-conducteur selon l'une quelconque des revendications 2-7, dans lequel une largeur de l'entrefer est supérieure à une épaisseur du premier espaceur, et
la largeur de l'entrefer est une distance entre les deux côtés de l'entrefer.

9. Dispositif à semi-conducteur selon une quelconque revendication précédente, dans lequel la structure de grille arrière inclut une première structure auxiliaire (136) sur l'électrode de grille arrière et la structure diélectrique, et
le motif vertical présente une partie s'étendant sur une surface latérale de la première structure auxiliaire le long d'une surface latérale de la structure diélectrique.

10. Dispositif à semi-conducteur selon la revendication 9, dans lequel la structure de grille avant comprend une couche de recouvrement de grille (166) sur l'électrode de grille, et
la surface inférieure de la première structure auxiliaire est à une hauteur sensiblement égale ou à une hauteur inférieure à la surface inférieure de la couche de recouvrement de grille.

11. Dispositif semi-conducteur selon une quelconque revendication précédente, dans lequel la seconde structure auxiliaire inclut :
une première couche (137a) recouvrant une surface inférieure de l'électrode de grille arrière et la surface inférieure de l'entrefer, et s'étendant vers le bas le long d'une surface latérale du motif vertical ; et
une seconde couche (137b) qui remplit l'intérieur de la première couche.

12. Dispositif à semi-conducteur selon une quelconque revendication précédente, dans lequel une surface supérieure de la seconde structure auxiliaire présente une première surface en contact avec l'électrode de grille arrière et une seconde surface définissant l'entrefer, la seconde surface étant disposée à une hauteur supérieure à la première surface.

13. Dispositif à semi-conducteur selon une quelconque revendication précédente, dans lequel une surface inférieure de l'électrode de grille est à une hauteur inférieure à une surface supérieure de la seconde structure auxiliaire.

14. Dispositif à semi-conducteur selon une quelconque revendication précédente, dans lequel une surface supérieure de la première région de source/drain du motif vertical se situe à la même hauteur ou à une hauteur inférieure à une extrémité inférieure de l'entrefer.
